# EUROPÄISCHE PATENTSCHRIFT

(11) **EP 1 050 598 B1**
(45) Veröffentlichungstag und Bekanntmachung des Hinweises auf die Patenterteilung: **15.06.2005**
(21) Anmeldenummer: 00107654.6
(22) Anmeldetag: 10.04.2000
(51) Int. Cl.: C23C 14/50, C23C 14/54, G02B 1/10

(54) **Vakuum-Beschichtungsanlage**
Vacuum coating apparatus
Appareil de dèpôt sous vide

(30) Priorität: 04.05.1999 CH 82399
(43) Veröffentlichungstag der Anmeldung: 08.11.2000
(73) Patentinhaber: Satis Vacuum Industries Vertriebs - AG, 6341 Baar (CH)
(72) Erfinder: Siegrist, Beat, 8704 Herrliberg (CH)
(74) Vertreter: Petschner, Goetz

(56) Entgegenhaltungen:
- EP-A- 0 748 881
- DE-A- 19 701 419
- US-A- 4 817 559
- US-A- 5 468 299

## Beschreibung

Die vorliegende Erfindung betrifft eine Vakuum-Beschichtungsanlage zum Aufdampfen von Vergütungsschichten auf optische Substrate, wie Kunststoff-Brillengläser, welche auf domförmige Trägermittel aufspannbar sind, die in einem evakuierbaren Rezipienten oberhalb von Verdampfungsquellen und gegebenenfalls zusätzlichen Wärmestrahlern umlaufen.

In der Vakuum-Beschichtungstechnik erweist es sich oft als notwendig, zur Erlangung einer optimalen Schichtqualität die zu beschichtenden Substrate während des Aufdampfprozesses einer definierten, erhöhten Temperatur auszusetzen. Hierfür werden üblich IR-Wärmestrahler eingesetzt.

Grundsätzlich problematisch hierbei ist allerdings die Überwachung der tatsächlichen Temperatur in der Beschichtungsebene mit ansich sinnvoll dort plazierten Temperaturfühlern, da eine anwendbare Messdatenübertragung vom rotierenden Dom auf den stationären Anlageteil bisher nicht ermöglicht werden konnte.

Demzufolge kennt der Stand der Technik nur Fühlermittel am stationären Anlageteil, die allerding keinen Aufschluss über die tatsächlichen Temperaturverhältnisse in der Beschichtungsebene geben können.

Aufgabe der vorliegenden Erfindung ist nun, entgegen bisheriger Praxis, bei einer Vakuum-Beschichtungsanlage zum Aufdampfen von Vergütungsschichten auf optische Substrate, wie Kunststoff-Brillengläser, welche auf domförmige Trägermittel aufspannbar sind, die in einem evakuierbaren Rezipienten oberhalb von Verdampfungsquellen und gegebenenfalls zusätzlichen Wärmestrahlern umlaufen, die Temperatur in der Beschichtungsebene der Substrate zu erfassen.

Dies wird erfindungsgemäss dadurch erreicht, dass mindestens ein Messfühler, insbesondere Temperaturfühler, an den umlaufenden Trägermitteln für die Substrate in mindestens angenähert deren Beschichtungsebene angeordnet ist, wobei der Messfühler mit elektrischen Schaltungsmitteln in Wirkungsverbindung steht zur tranformatorischen Energieübertragung zwischen stillstehendem Teil der Beschichtungsanlage und umlaufenden Trägermitteln.

Hierdurch kann nun die elektrische Energieübertragung von einem stationären Primär-Schaltkreis auf einen relativ zu diesem bewegbaren Sekundär-Schaltkreis sowie eine Rückübertragung von im Sekundär-Schaltkreis erzeugten Messdaten auf den Primär-Schaltkreis erfolgen, wobei im Primär-Schaltkreis eine Primärspannung erzeugt und diese transformatorisch auf den Sekundär-Schattkreis übertragen wird und wobei dann die im Sekundär-Schaltkreis erzeugten Messdaten digital umgeformt und auf dem gleichen transformatorischen Weg auf den Primär-Schaltkreis rückübertragen und dort ausgewertet werden können.

Hierfür umfassen die Schaltungsmittel einen Primär-Schaltkreis und einen Sekundär-Schaltkreis, wobei der Primär-Schaltkreis über einen Transformator mit dem Sekundär-Schaltkreis berührungsfrei gekoppelt ist. Ferner umfasst der Transformator eine Primär-Spule im Primär-Schaltkreis auf einem stationären Kern und eine Sekundär-Spule im Sekundär-Schaltkreis auf einem relativ zum stationären Kern bewegbaren Kern.

Im Primär-Schaltkreis befindet sich weiter eine Spannungsquelle sowie eine Auswerteeinrichtung für die induzierten Messdaten und im Sekundär-Kreislauf neben dem Messdaten erzeugenden Temperaturfühler eine die Messdaten digitalisierende Auswerteeinrichtung, deren Ausgangssignale einen Kurschlusserzeuger steuern.

Erfindungswesentlich ist dabei, dass die Primär-Spule mit dem stationären Kern und die Sekundär-Spule mit dem bewegbaren Kern koaxial und relativ zueinander umlaufend angeordnet sind.

Hierbei erhält der mit dem Sekundär-Schaltkreis bewegte Messfühler seine Energie transformatorisch aus dem Primär-Schaltkreis, wobei die vom Messfühler erzeugten Strom- und Spannungs-Messdaten zu der Auswerteeinrichtung gelangen und die in digitale Ausgangssignale umgeformten Messdaten einen Kurzschlusserzeuger steuern, welcher den Strom im Sekundär-Schaltkreis gemäss dem Messdatenverlauf kurzschliesst. Die hierbei im Primär-Schaltkreis induzierten äquivalenten Strom- und Spannungsänderungssignale gelangen dann zur Auswerteeinrichtung im Primär-Schaltkreis und sind dort in verwertbare Ausgangssignale überführbar, beispielsweise zur Nachregelung der Wärmestrahler.

Eine beispielsweise Ausführungsform der erfindungsgemässen Vakuum-Beschichtungsanlage ist nachfolgend anhand der Zeichnung näher erläutert. Es zeigen:
- Fig.1: eine Vakuum-Beschichtungsanlage, im Schnitt, mit einem Temperaturfühler, der mit elektrischen Schaltungsmitteln in Wirkungsverbindung steht zur tranformatorischen Energieübertragung zwischen stillstehendem Teil der Beschichtungsanlage und umlaufenden Trägermitteln; und
- Fig.2: ein Schaltschema der Schaltungsmittel gemäss Fig. 1 mit einem Primär-Schaltkreis, der über einen Transformator mit einem Sekundär-Schaltkreis berührungsfrei gekoppelt ist.

Die gezeigte Vakuum-Beschichtungsanlage dient zum Aufdampfen von Vergütungsschichten auf optische Substrate 10, wie Kunststoff-Brillengläser, welche auf domförmige Trägermittel 1 aufspannbar sind, die in einem evakuierbaren Rezipienten 2 oberhalb von Verdampfungsquellen 20 und gegebenenfalls zusätzlichen Wärmestrahlem 21 umlaufen.

Der Aufbau solcher Vakuum-Aufdampfanlagen ist soweit bekannt, dass sich eine nähere Konstruktionsbeschreibung erübrigt.

Erfindungswesentlich ist hier zunächst, dass mindestens ein Messfühler 3, insbesondere Temperaturfühler, an den umlaufenden Trägermitteln 1 für die Substrate 10 in mindestens angenähert deren Beschichtungsebene angeordnet ist, wobei der Messfühler 3 mit elektrischen Schaltungsmitteln 11,13 in Wirkungsverbindung steht zur tranformatorischen Energieübertragung zwischen stillstehendem Teil 2 der Beschichtungsanlage und umlaufenden Trägermitteln 1.

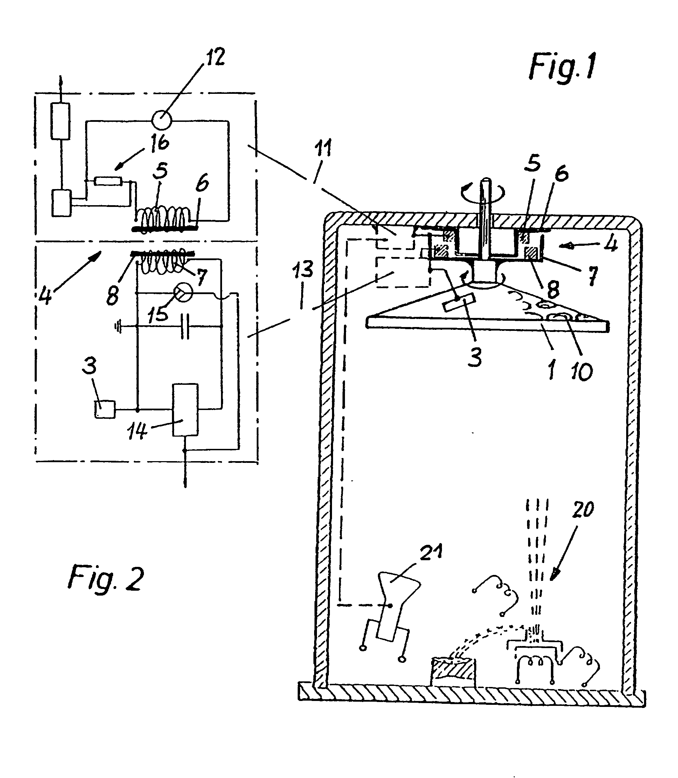

Wie in Fig. 1 angedeutet und wie das betreffende Schaltschema in Fig. 2 deutlich macht, umfassen die Schaltungsmittel einen Primär-Schaltkreis 11 und einen Sekundär-Schaltkreis 13, wobei der Primär-Schaltkreis 11 über einen Transformator 4 mit dem Sekundär-Schaltkreis 13 berührungsfrei gekoppelt ist.

Dieser Transformator 4 umfasst eine Primär-Spule 5 im Primär-Schaltkreis auf einem stationären Kern 6 und eine Sekundär-Spule 7 im Sekundär-Schaltkreis auf einem relativ zum stationären Kern bewegbaren Kern 8.

Hierbei befinden sich im Primär-Schaltkreis eine Spannungsquelle 12 sowie eine Auswerteeinrichtung 16 für die induzierten Messdaten und im Sekundär-Schaltkreis, neben dem Messdaten erzeugenden Temperaturfühler 3, eine die Messdaten digitalisierende Auswerteeinrichtung 14, deren Ausgangssignale einen Kurzschlusserzeuger 15 steuern.

Die Primär-Spule mit dem stationären Kern und die Sekundär-Spule mit dem bewegbaren Kern sind koaxial und relativ zueinander umlaufend angeordnet, wie das Fig. 1 erkennen lässt.

Der mit dem Sekundär-Schaltkreis 13 bewegte Messfühler 3 erhält nun seine Energie transformatorisch aus dem Primär-Schaltkreis 11, wobei die vom Messfühler 3 erzeugten Strom- und Spannungs-Messdaten zu der Auswerteeinrichtung 14 gelangen, wobei dann die in digitale Ausgangssignale umgeformten Messdaten einen Kurzschlusserzeuger 15 steuern, welcher den Strom im Sekundär-Schaltkreis 13 gemäss dem Messdatenverlauf kurzschliesst. Die im Primär-Schaltkreis 11 induzierten äquivalenten Strom- und Spannungsänderungssignale sind dann mit der Auswerteeinrichtung 16 im Primär-Schaltkreis 1 in verwertbare Ausgangssignale überführbar.

Durch diese Massnahmen wird es also grundsätzlich möglich, eine elektrische Energieübertragung von einem stationären Primär-Schaltkreis auf einen relativ zu diesem bewegbaren Sekundär-Schaltkreis sowie eine Rückübertragung von im Sekundär-Schaltkreis erzeugten Messdaten auf den Primär-Schaltkreis in einer heute angemessenen Weise zu gestatten, indem im Primär-Schaltkreis eine Primärspannung erzeugt und diese transformatorisch auf den Sekundär-Schaltkreis übertragen wird und dann die im Sekundär-Schaltkreis erzeugten Messdaten digital umgeformt und auf dem gleichen transformatorischen Weg auf den Primär-Schaltkreis rückübertragen und dort ausgewertet werden.

Somit ist es nunmehr möglich, Fühlermittel direkt in der Beschichtungsebene der Subtrate anzuordnen und die sich ergebenden Messdaten, wie Temperatur u. dgl., aufzunehmen und zu verwerten.

Selbstverständlich sind im Rahmen der vorbeschriebenen Erfindung eine ganze Reihe von Modifikationen möglich, ohne dabei den Erfindungsgedanken zu verlassen. So kann der Messfühler beliebiger Art sein. Weiter kann der Sekundär-Schaltkreis auch mehrere gleiche oder unterschiedliche Messfühler umfassen. Entsprechend sind dann Auswerteeinrichtung und Kurzschlusserzeuger im Sekundär-Schaltkreis sowie die Auswerteeinrichtung im Primär-Schaltkreis auszulegen.

Es wird Schutz beansprucht wie folgt:

## Patentansprüche

1. Vakuum-Beschichtungsanlage zum Aufdampfen von Vergütungsschichten auf optische Substrate (10), wie Kunststoff-Brillengläser, welche auf domförmige Trägermittel (1) aufspannbar sind, die in einem evakuierbaren Rezipienten (2) oberhalb von Verdampfungsquellen (20) und gegebenenfalls zusätzlichen Wärmestrahlem (21) umlaufen,
**dadurch gekennzeichnet,**
**dass** mindestens ein Messfühler (3), insbesondere Temperaturfühler, an den umlaufenden Trägermitteln (1) für die Substrate (10) in mindestens angenähert deren Beschichtungsebene angeordnet ist, wobei der Messfühler (3) mit elektrischen Schaltungsmitteln (11,13) in Wirkungsverbindung steht zur tranformatorischen Energieübertragung zwischen stillstehendem Teil (2) der Beschichtungsanlage und umlaufenden Trägermitteln (1).

2. Vakuum-Beschichtungsanlage nach Anspruch 1, **dadurch gekennzeichnet, dass** die Schaltungsmittel einen Primär-Schaltkreis (11) und einen Sekundär-Schaltkreis (13) umfassen, wobei der Primär-Schaltkreis (11) über einen Transformator (4) mit dem Sekundär-Schaltkreis (13) berührungsfrei gekoppelt ist.

3. Vakuum-Beschichtungsanlage nach Anspruch 2, **dadurch gekennzeichnet, dass** der Transformator (4) eine Primär-Spule (5) im Primär-Schaltkreis auf einem stationären Kern (6) und eine Sekundär-Spule (7) im Sekundär-Schaltkreis auf einem relativ zum stationären Kern bewegbaren Kern (8) umfasst.

4. Vakuum-Beschichtungsanlage nach Anspruch 3, **dadurch gekennzeichnet, dass** sich im Primär-Schaltkreis eine Spannungsquelle (12) sowie eine Auswerteeinrichtung (16) für die induzierten Messdaten befinden und sich im Sekundär-Schaltkreis neben dem Messdaten erzeugenden Temperaturfühler (3) eine die Messdaten digitalisierende Auswerteeinrichtung (14) befindet, deren Ausgangssignale einen Kurzschlusserzeuger (15) steuern.

5. Vakuum-Beschichtungsanlage nach Anspruch 3, **dadurch gekennzeichnet, dass** die Primär-Spule mit dem stationären Kern und die Sekundär-Spule mit dem bewegbaren Kern koaxial und relativ zueinander umlaufend angeordnet sind.

6. Vakuum-Beschichtungsanlage nach Anspruch 3, **dadurch gekennzeichnet, dass** der mit dem Sekundär-Schaltkreis (13) bewegte Messfühler (3) seine Energie transformatorisch aus dem Primär-Schaltkreis (11) erhält, dass die vom Messfühler (3) erzeugten Strom- und Spannungs-Messdaten zu der Auswerteeinrichtung (14) gelangen und dass die in digitale Ausgangssignale umgeformten Messdaten einen Kurzschlusserzeuger (15) steuern, welcher den Strom im Sekundär-Schaltkreis (13) gemäss dem Messdatenverlauf kurzschliesst.

7. Vakuum-Beschichtungsanlage nach Anspruch 4 oder 6, **dadurch gekennzeichnet, dass** die im Primär-Schaltkreis (11) induzierten äquivalenten Strom- und Spannungsänderungssignale über die Auswerteeinrichtung (16) im Primär-Schaltkreis (1) gelangen und dort in verwertbare Ausgangssignale überführbar sind.

## Claims

1. Vakuum coating apparatus to deposit blooming coats on optical substrates (10) such as plastic glasses that can be clamped onto dome-shaped supports (1) which rotate in evacuable recipients (2) above vaporization sources (20) and possibly additional thermal radiators (21), **characterized in that** at least at least one sensor (3), especially a thermometer, is on the revolving supports (1) for the substrates (10) at least close to the coating layer, whereby the sensor (3) is connected via electrical circuits (11, 13) to a transformer that transmits energy between the stationary part (2) of the coating system and the revolving supports (1).

2. Vakuum coating apparatus according to claim 1, **characterized in that** circuitry comprises a primary circuit (11) and a secondary circuit (13), whereby the primary circuit (11) is coupled via a transformer (4) to the secondary circuit (13) free of contact.

3. Vakuum coating apparatus according to claim 2, **characterized in that** the transformer (4) has a primary coil (5) in the primary circuit on a stationary core (6), and a secondary coil (7) in the secondary circuit on a mobile core (8) that moves relative to the stationary core.

4. Vakuum coating apparatus according to claim 3, **characterized in that** a voltage source (12) and an evaluator (16) for the induced measured data are in the primary circuit, and thermometers (3) that generate measured data are in the secondary circuit along with an evaluator (14) that digitizes the measured data whose output signals control a short-circuit generator (15).

5. Vakuum coating apparatus according to claim 3, **characterized in that** the primary coil with the stationary core and the secondary coil with the mobile core are coaxial to each other and rotate relative to each other.

6. Vakuum coating apparatus according to claim 3, **characterized in that** the sensors (3) moved with the secondary circuit (13) receive their energy via a transformer from the primary circuit (11); the measured current and voltage data generated by the sensor (3) then reach the evaluator (14); and the measured data that are transformed into digital output signals control a short-circuit generator (15) that short-circuits the current in the secondary circuit (13) according to the measured data characteristic.

7. Vakuum coating apparatus according to claims 4 or 6, **characterized in that** equivalent current and voltage change signals induced in the primary circuit (11) then reach the evaluator (16) in the primary circuit (1) and are transformed there into an evaluatable output signals.

## Revendications

1. Appareil de dépôt sous vide pour la métallisation sous vide de couches de traitement sur des substrats optiques (10), comme des verres de lunettes en matériau synthétique, qui peuvent être serrées sur des moyens de support (1) en forme de dôme, qui tournent dans un récipient (2) pouvant être évacué au-dessus de sources d'évaporation (20) et le cas échéant de radiateurs thermiques additionnels (21),
**caractérisé**
**en ce qu'**au moins un capteur de mesure (3), en particulier un capteur de température, est disposé aux moyens de support tournants (1) pour les substrats (10) au moins à proximité de leur plan de dépôt, où le capteur de mesure (3) est en liaison fonctionnelle avec des moyens de commutation électriques (11, 13) en vue de la transmission transformatrice d'énergie entre la partie immobile (2) de l'appareil de dépôt et des moyens de supports tournants (1).

2. Appareil de dépôt sous vide selon la revendication 1, **caractérisé en ce que** les moyens de commutation comprennent un circuit de commutation primaire (11) et un circuit de commutation secondaire (13), où le circuit de commutation primaire (11) est couplé sans contact par un transformateur (4) au circuit de commutation secondaire (13).

3. Appareil de dépôt sous vide selon la revendication 2, **caractérisé en ce que** le transformateur (4) comprend une bobine primaire (5) dans le circuit de commutation primaire sur un noyau stationnaire (6) et une bobine secondaire (7) dans le circuit de commutation secondaire sur un noyau (8) déplaçable relativement au noyau stationnaire.

4. Appareil de dépôt sous vide selon la revendication 3, **caractérisé en ce que** se trouvent dans le circuit de commutation primaire une source de tension (12) ainsi qu'une installation d'évaluation (16) pour les données de mesure induites et qu'il se trouve dans le circuit de commutation secondaire, à côté du capteur de température (3) produisant les données de mesure, une installation d'évaluation (14) convertissant en numérique les données de mesure, dont les signaux de sortie commandent un générateur de court-circuit (15).

5. Appareil de dépôt sous vide selon la revendication 3, **caractérisé en ce que** la bobine primaire avec le noyau stationnaire et la bobine secondaire avec le noyau mobile sont disposées coaxialement et de manière tournante l'une relativement à l'autre.

6. Appareil de dépôt sous vide selon la revendication 3, **caractérisé en ce que** le capteur de mesure (3) déplacé avec le circuit de commutation secondaire (13) reçoit son énergie par transformation du circuit de commutation primaire (11), **en ce que** les données de mesure de courant et de tension produites par le capteur de mesure (3) sont transmises à l'installation d'évaluation (14) et **en ce que** les données de mesure transformées en signaux de départ numériques commandent un générateur de court-circuit (15) qui court-circuite le courant dans le circuit de commutation secondaire (13) selon la courbe des données de mesure.

7. Appareil de dépôt sous vide selon la revendication 4 ou 6, **caractérisé en ce que** les signaux de modification de courant et de tension équivalents induits dans le circuit de commutation primaire (11) arrivent par l'installation d'évaluation (16) dans le circuit de commutation primaire (1) et peuvent y être transformés en des signaux de sortie utilisables.
